# EUROPEAN PATENT APPLICATION

(11) **EP 2 530 843 A2**
(43) Date of publication of application: **05.12.2012**
(21) Application number: 12160399.7
(22) Date of filing: 20.03.2012
(51) Int. Cl.: H03M 7/30

(54) **Dictionary based data compression**

(30) Priority: 03.06.2011 IN CH19002011
(71) Applicant: Alcatel Lucent, 75007 Paris (FR)
(72) Inventor: Jash, Shaswata, 560045 BANGALORE (IN)
(74) Representative: Mouney, Jérôme

(57) **Abstract**

The embodiments herein relate to data compression algorithms and, more particularly, to a pattern aware compression schemes (PACS). The propsed PACS scheme is highly aggressive in learning repeated patterns. Run-time complexity of PACS decompression is constant order. Further, in the proposed PACS scheme, memory requirement to maintain the dictionary is effectively controlled by exploiting super imposition in pattern trees.

## Description

### TECHNICAL FIELD

The embodiments herein relate to data compression algorithms and, more particularly, to a pattern aware compression schemes (PACS) in data compression mechanisms.

### BACKGROUND

Nowadays internet is one of the common means of extracting information. Data transfer is one of the main applications of the Internet. Further, the internet bandwidth available over a given time is fixed. Data transfer is possible only within the allowed band width. Data compression allows transfer of large sized data over the available bandwidth. By compressing the data, storage as well as data transfer can be done effectively as it helps to reduce consumption of resources such as memory, bandwidth and so on. In case of data transfer schemes, data is compressed in the transmission end using a compression algorithm and the compressed data is sent over the network. This data is decompressed at the receiving end in order to obtain the original data using any decompression algorithm.

Data compression is mainly classified into two categories namely loss less and lossy compression. Lossless compression is reversible so that the original data can be reconstructed whereas lossy data compression schemes accept some loss of data so as to achieve higher compression. Loss less data compression schemes are to be implemented in cases where the data to be compressed is anything like text, executable programs and so on. In case of these data, loss of even a single bit cannot be tolerated. When the data to be compressed is audio, video and the like some loss of quality can be tolerated without losing essential nature of data. By doing this, large amount of storage space can be saved. Data compression is achieved using data compression algorithms. Separate algorithms are to be used depending upon the type of data compression to be achieved.

Some of the classes of algorithms used these days for data compression are Huffman's coding, arithmetic coding, Dictionary based / Substitutional algorithm and so on. Algorithms like Huffman's coding try to find probabilities of occurrence of symbols. Therefore Huffman's coding comes under probabilistic compression. Foremost problem in Huffman encoding is that the encoder has to make double passes on the input to effectively exploit the probabilistic occurrence of the symbols. The first pass determines the probability and then, the second pass does the actual compression according to Huffman code tree. Also, in Huffman compression, decoder has to beforehand (i.e. before start of decompression process) know the probabilistic model determined by the encoder to create the Huffman tree in its own side. Though arithmetic-code (coupled with inter-symbol probability based model prediction algorithms e.g. DMC-Dynamic Markov Coding, PPM-Prediction by Partial-matching) are the most powerful class of compression algorithm, but they consume rather large amounts of computing resources both in terms of CPU occupancy and memory usage. Arithmetic-coding by its inherent nature, is extremely arithmetic computational intensive. The third class of the compression algorithm i.e. dictionary based /substitutional algorithm is the compromise in the middle.

Dictionary based algorithm stores repeated patterns as present in the input into a dictionary tree. In the tree, repeated patterns are represented using unique codes. Some of the dictionary tree patterns already in use are LZ77 and LZ78.

LZ77 is a dictionary based algorithm which is famously known through its variant DEFLATE. DEFLATE uses a search buffer so as to represent longest possible repeated pattern and the decoder is using indexes in the search buffer to find a pattern. In this case, a dictionary tree is not explicitly maintained and hence, the memory footprint is very less as the algorithm requires memory only for the search buffer. But in this scheme, search operation is costly as the encoder has to always start search from the beginning of search buffer. In LZ77, atleast two data (starting position of the code and length of the pattern) are required to represent the code. Further, LZ77 can not find repeated patterns which are present before the present position of search buffer.

LZ78 is another dictionary based algorithm which is used for the purpose of data compression. LZ78 ensures higher speed of data compression as unlike LZ77, the encoder explicitly maintains a dictionary and thus can search the pattern in constant order within the dictionary. To create such explicit dictionary, LZ78 reads each symbol one after another and verifies whether the new pattern generated by appending the input symbol at the end of previously accumulated pattern is present in the dictionary. If it is not found, LZ78 inserts the accumulated pattern into the dictionary and re-initializes the accumulated pattern with the present input symbol. .Thus compression efficiency of LZ78 is highly dependent on the fact how aggressively it can find the longest possible repeated patterns. But the learning ability of LZ78 is less because it can maximum learn one pattern for every new input symbol. This directly affects compression efficiency when there are many repeated patterns of the same string. LZAP is improved variant of LZ78 which improves the aforementioned weakness in LZ78. To improve the aggressiveness in learning patterns, LZAP adds the concatenations of previous match with-each initial substring of the current match. Therefore, LZAP has got better learning ability as compared to any other algorithms present in the LZ78 class. But still, LZAP is not able to achieve the aggressiveness in learning of repeated patterns as claimed in the present scheme namely PACS.

Further, in all the variant of LZ78, there is a fundamental problem in the decompression side. Decompression requires reverse-mapping the code to the pattern present in the dictionary. Fastest way of such search is through balanced tree where successful search in the balanced can be done in logarithmic order of the total number of codes. To make such search in the decompressor in constant order, the maximum number of allowed codes is kept fixed - this ensures the search can be done in order of one through array index. But side-effect of such limiting mandates that older codes are flushed out when the scheme reaches the allowed limit of maximum number of codes. This behavior has inherent assumption that the repeated patterns are localized in the input which can reduce compression efficiency if there is possibility of repetition of patterns from quite an old section of the input.

Due to the aforementioned reasons existing dictionary based compression schemes are not effective. This is because their compression efficiency is low, runtime complexity (specifically in the decompressor side) involved is more and memory employed by these data compression schemes is relatively larger.

### SUMMARY

In view of the foregoing, an embodiment herein provides a method for compressing data by employing a pattern aware compression scheme. The method comprising steps of passing an input through a shift buffer for identifying different possible sequences of the input, creating a pattern tree in order to identify possible repeating patterns of the input, identifying a longest repeated pattern from the created pattern tree and assigning unique codes to the repeated pattern. The method passes the input through the shift buffer by inserting a new symbol at the tail of the shift buffer and deleting an old symbol from the head of the shift buffer. The method creates the pattern tree by rooting trees at a particular symbol and storing patterns starting with the symbol, identifying intermediate/leaf nodes for the rooted-tree and traversing the tree nodes to identify possible patterns starting with the root node. The method traverses the tree nodes by employing depth first traversal algorithm. The method identifies the longest repeated pattern by determining the pattern that takes the longest traversal (in terms of depth) from the root node to a child node. The method assigns unique codes to the repeated pattern, where the unique codes are determined by the number of traversals taken to reach the end of the pattern tree. The method further determines length of bit codes by computing minimum bits that are required to represent the total number of nodes of the tree present in the created pattern tree.

Embodiments further disclose a method for superimposing repeated patterns to achieve space optimization in data compression schemes. The method comprising steps of identifying if patterns between two different rooted trees share common nodes, and replacing the set of common nodes with a single node. The method further identifies those replaced set of nodes from the single node by traversing the pattern tree in reverse order (i.e. traversing from child node to parent starting from the leaf node of the tree-branch).

Embodiments herein also disclose an encoder for compressing data by employing pattern aware compression schemes. The encoder is configured for passing an input through a shift buffer for identifying different possible sequences of the input creating a pattern tree in order to identify possible repeating patterns of the input, identifying a longest repeated pattern from the created pattern tree and assigning unique codes to the repeated pattern. The encoder is further configured for passing the input through the shift buffer by inserting a new symbol at the tail of the shift buffer and deleting an old symbol from the head of the shift buffer. The encoder is further configured for creating the pattern tree by rooting trees at a particular symbol and storing patterns starting with the symbol, identifying child nodes for the rooted nodes and traversing the tree nodes to identify possible patterns starting with the root node. The encoder is further configured for traversing the tree nodes by employing depth first traversal algorithm. The encoder is further configured for identifying the longest repeated pattern by determining the pattern that takes the longest traversal (in terms of depth) from the root node to a child node. The encoder is further configured for - assigning unique codes to the repeated pattern, where the unique codes are determined by the number of traversals taken to reach the end of the pattern tree. The encoder is further configured for determining the length of bit codes by computing minimum bits that are required to represent the total number of nodes of the tree present in the created tree pattern.

Also, disclosed herein is a decoder for decoding compressed data in a pattern aware compressing scheme. The decoder is configured for replacing the unique codes with the patterns from the pattern tree, creating the pattern tree from the decoded patterns. The decoder is further configured for creating the pattern tree by rooting trees at a particular symbol and storing patterns starting with the symbol, identifying child nodes for the rooted nodes and traversing the tree nodes to identify possible patterns starting with the root node. The decoder traverses the tree nodes by employing depth first traversal algorithm. The decoder is further configured for - replacing the unique codes to the repeated pattern, where the unique codes are the number of traversals taken to reach the target node corresponding to the last symbol in the pattern. Such synchronized process between decoder and encoder guarantees that encoder need not send any explicit dictionary to decoder - decoder can independently develop the pattern tree without any explicit help from the encoder.

Also, disclosed herein is a method for decompressing data in a pattern aware compressing scheme. The method performs steps of identifying repeated patterns for unique codes in a pattern tree, replacing the unique codes with the repeated patterns for the pattern tree, creating the pattern tree from the repeated patterns. The method is further configured for creating the pattern tree by rooting trees at a particular symbol and storing patterns starting with the symbol, identifying child nodes for the rooted nodes and traversing the tree nodes to identify possible patterns starting with the root node. The method traverses the tree nodes by employing depth first traversal algorithm. The method is further configured for replacing the unique codes to the repeated pattern, where the unique codes are the number of traversals taken to reach the end of the pattern tree.

These and other aspects of the embodiments herein will be better appreciated and understood when considered in conjunction with the following description and the accompanying drawings.

### BRIEF DESCRIPTION OF THE FIGURES

The embodiments herein will be better understood from the following detailed description with reference to the drawings, in which:

FIG. 1 illustrates a broad-level flow diagram which describes the process of compressing the data according to the system disclosed herein;

FIG. 2 illustrates a detailed flow diagram which describes the operation of pattern aware compression scheme (PACS) as disclosed herein;

FIG. 3 illustrates a block diagram of the use case scenario of the Pattern Aware Compression Schemes (PACS) for compressing wireless data in the UMTS protocol stack of the system as disclosed in the embodiments herein;

FIG. 4a and 4b illustrates a block diagram of the hardware component of the packet server present in Radio Network Controller (RNC) to implement PACS in the aforementioned use-case as disclosed in the embodiments herein;

FIG. 5 illustrates use case scenario of PACS in the context of compressing wire-line data between two end-points of Internet (also known as tunnels) as disclosed in the embodiments herein; and

FIG. 6a and 6b illustrates use case scenario of PACS in the context of traditional usage of compression in storage space as disclosed in the embodiments herein.

### DETAILED DESCRIPTION OF EMBODIMENTS

The embodiments herein and the various features and advantageous details thereof are explained more fully with reference to the non-limiting embodiments that are illustrated in the accompanying drawings and detailed in the following description. Descriptions of well-known components and processing techniques are omitted so as to not unnecessarily obscure the embodiments herein. The examples used herein are intended merely to facilitate an understanding of ways in which the embodiments herein may be practiced and to further enable those of skill in the art to practice the embodiments herein. Accordingly, the examples should not be construed as limiting the scope of the embodiments herein.

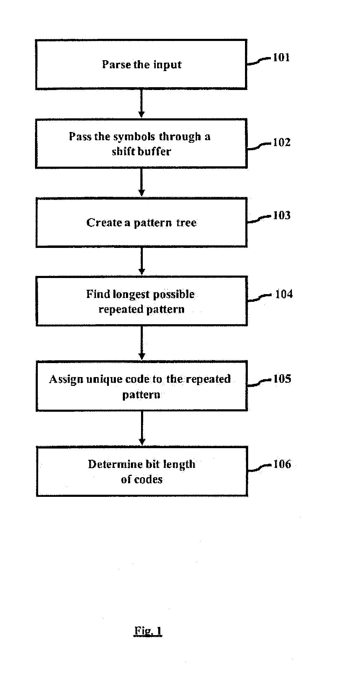

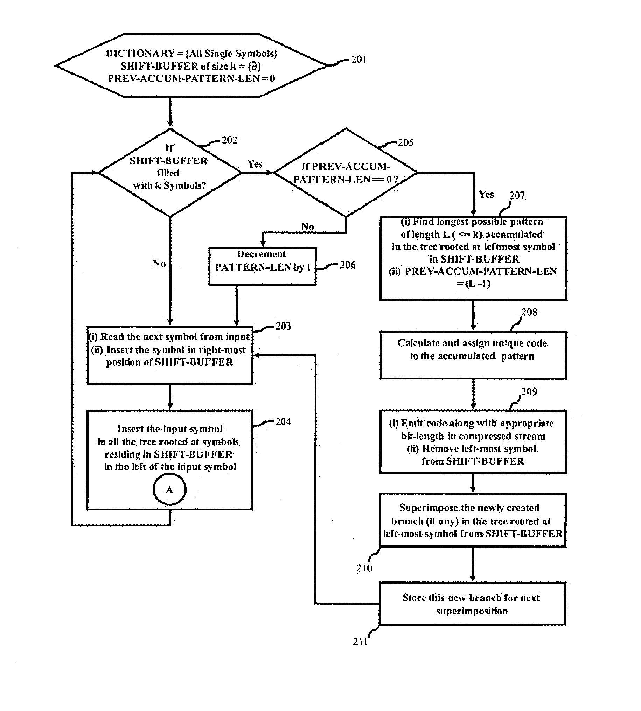

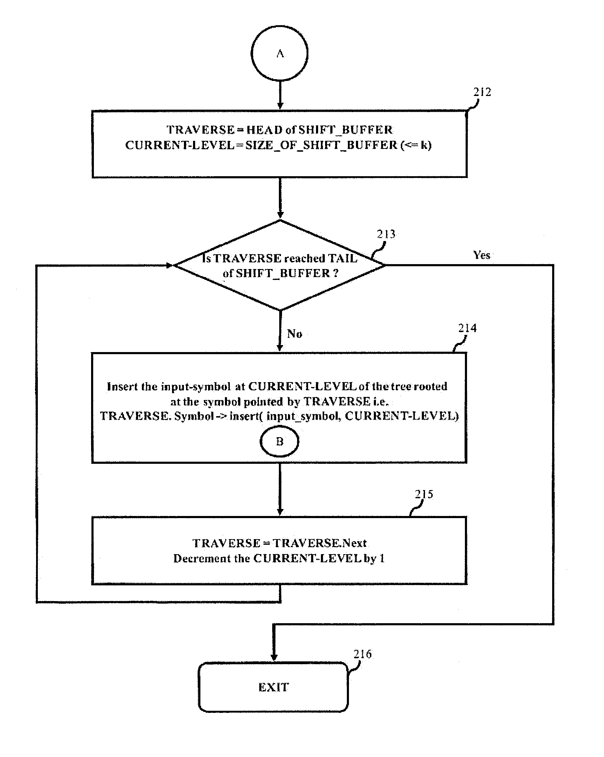

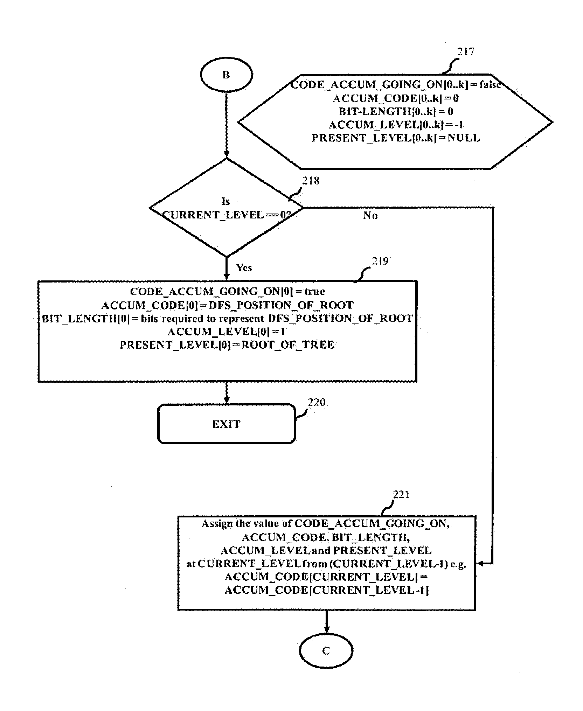

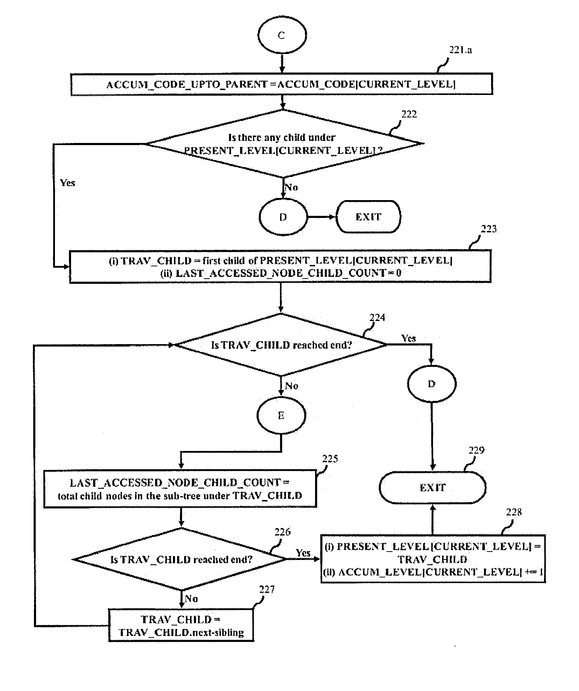

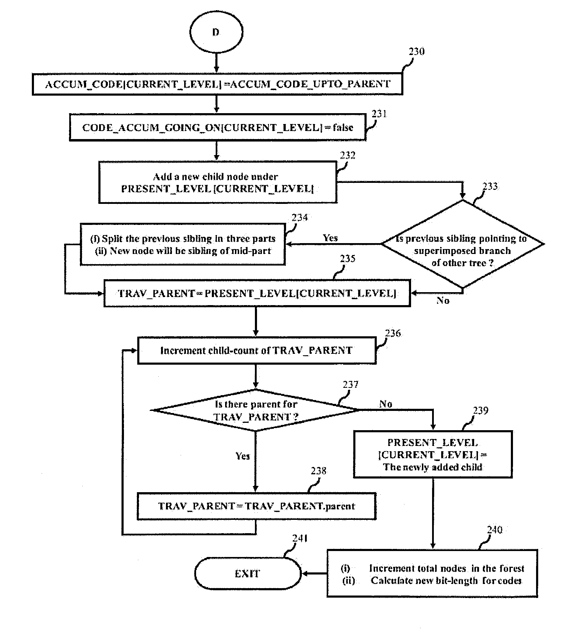

The embodiments herein disclose a process of achieving data compression by using data compression algorithm which is termed as Pattern Aware Compression Scheme (PACS). Referring now to the drawings, and more particularly to FIGS. 1 through 6, where similar reference characters denote corresponding features consistently throughout the figures, there are shown embodiments.

FIG. 1 illustrates a broad-level flow diagram which describes the process of compressing the data according to the system disclosed herein. The data to be compressed is the input to the parser. The data is parsed (101) by the parser and the parsed data is fed (102) to the input of shift register. The shift buffer acts as a linked list of fixed size, say "k". Data is inserted at the tail of the list. When the buffer length reaches the maximum buffer count i.e., the list has already been filled upto 'k' nodes, then for the insertion of each input, data will get deleted from the head of the list. That means oldest data in the list will get deleted first. Then using the data obtained at the output of shift buffer, a pattern tree is created (103). In the tree, a depth - first - search is performed in order to find (104) the longest possible (lesser than length 'k') repeated pattern. The depth - first - search is performed by expanding first child node of the tree and then going deeper and deeper until the goal node (i.e. having the last symbol of the repeated pattern) is found. Once the longest possible repeated pattern is found, a unique code is assigned (105) to the pattern. After assigning unique code to all repeated patterns, the system calculates (106) bit length of the codes. The length of the code is determined by the minimum bits required to represent the total number of "tree nodes" present in the complete dictionary. The various actions in method 100 may be performed in the order presented, in a different order or simultaneously. Further, in some embodiments, some actions listed in FIG. 1 may be omitted.

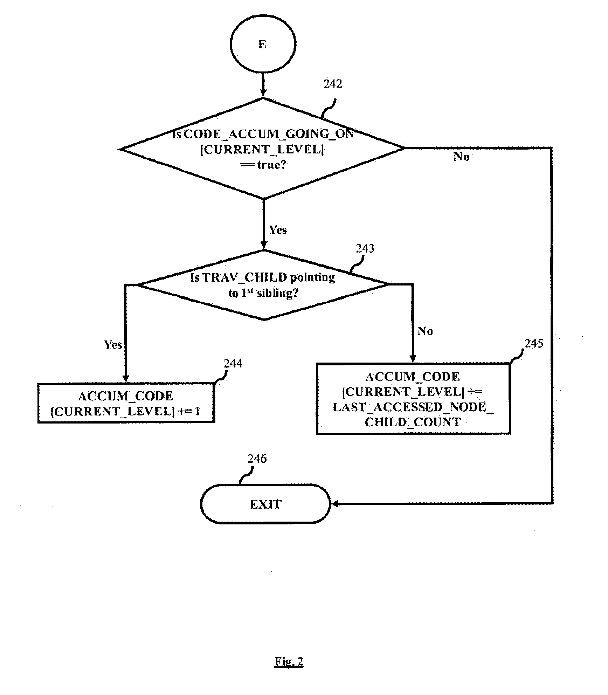

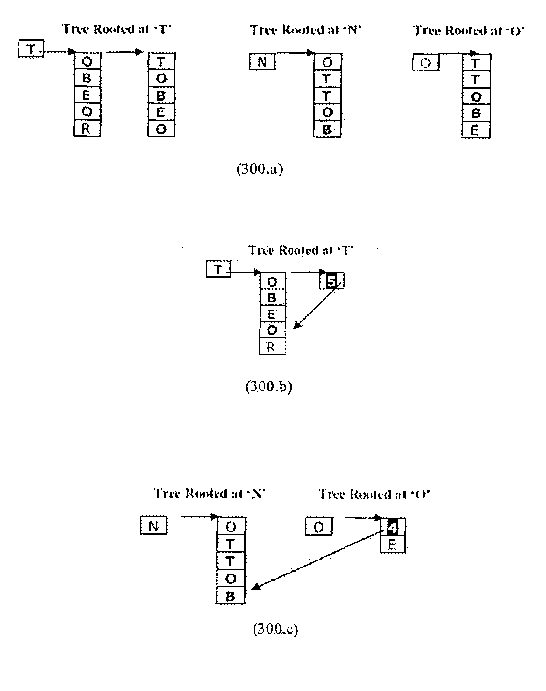

FIG. 2 illustrates a detailed flow diagram which describes the operation of pattern aware compression scheme as disclosed herein. Initially the data is parsed into symbols. A shift buffer of a fixed length (k) is used in the system. The value of previous accumulated pattern length is initialized to zero. The dictionary data structure is also initialized. Then the system checks (202) if the shift buffer is filled with k symbols (maximum size of the shift buffer) or not. If not, the next symbol from the input is read and is inserted (203) to the right most position of the shift buffer. The input symbol is then inserted (204) in all the trees rooted at symbols residing in shift_buffer in the left of the input symbol. The step described in 204 further comprises the following steps. Traversal starts from the head of the shift buffer and the size of shift buffer is assigned (212) to the current level. Then the system checks (213) if the traversal has reached the end of shift buffer or not. If yes, the process terminates (216) and the control goes to 202. If not, input symbol is inserted (214) at the current level of the tree rooted at the symbol pointed by the traverse which further comprises the following steps.

Below mentioned are some parameters and their functions being used within the process. These parameters are for the purposes of illustrating the application details and do not aim to limit the scope of the application. Further, the parameters may be replaced or modified accordingly to suit the application. All such variations fall within the scope of this application.

CODE_ACCUM_GOING_ON signifies whether the pattern is accumulating within its respective pattern tree, ACCUM_CODE holds the unique code representing the accumulated pattern, BIT_LENGTH holds the bits required to represent that code, ACCUM_LEVEL holds the length of the accumulated pattern (in other words the depth of the node holding the last symbol of the pattern from the root node of the pattern tree), PRESENT_LEVEL holds the link address of the node up to which the scheme has depth-traversed in that particular tree. Each of the above parameters is array of size 'k' and maintained per pattern tree. Note that default values are assigned (217) to these parameters at the start of the whole scheme (i.e. along with execution of 201).

The system first checks (218) if the present level is equal to zero or not. If yes, the present level is assigned as the root of the tree and the values of CODE-ACCUM-GOING-ON, ACCUM_CODE, BIT_LENGTH, ACCUM_LEVEL and PRESENT_LEVEL are updated (219) with initialization values and the process gets terminated (220) and the control goes to 215. ACCUM_CODE [0] is initialized with the Depth First Search (DFS) position of the root node of the pattern tree with respect to the whole forest. BIT_LENGTH [0] is initialized with total number of bits required to represent the maximum number of nodes in the whole forest. If the current level is not equal to zero, parameters like CODE_ACCUM_GOING_ON, ACCUM_CODE, BIT_LENGTH, ACCUM_LEVEL and the PRESENT_LEVEL are assigned with the values from the previous level (221).

After 221, the system first assigns (221.a) ACCUM_CODE [CURRENT_LEVEL] to temporary parameter called ACCUM_CODE_UPTO_PARRENT and checks (222) if there is any child node under the present level or not. If not, this is the case when the first child under a particular parent node is created. This means that pattern cannot be accumulated, thus values of CODE_ACCUMULATION_GOING_ON [CURRENT_LEVEL] is set to false (230) and ACCUM_CODE [PRESENT_LEVEL] is updated from the temporarily maintained parameter ACCUM_CODE_UPTO_PARENT (231). Then a new child node is added (232) under the present level. While adding a new child-node, the system checks (233) if the previous sibling is pointing to the super imposed branch of the other tree. If yes, the previous sibling is split (234) into three parts and the new node is assigned as the sibling of mid part.

On addition of a new child-node, the underneath child-count has to be incremented for all the parents above that new child-node. Thus present level is assigned (235) to a parameter named TRAV_PARENT. Underneath child-count of TRAV_PARENT is incremented by one (236). Then it is checked (237) whether TRAV_PARENT has any parent. If not, PRESENT_LEVEL [CURRENT_LEVEL] is assigned (239) to the newly added child-node (added in 234). If parent of TRAV_PARENT found, TRAV_PARENT points to the parent (238) and the control goes to 236. This flow ensures that for every new node added, the underneath child count is incremented for all the parents until the root node of the respective pattern tree. Such updation of underneath child count is needed so that the scheme need not traverse all the nodes in the tree to calculate depth-first-traversal code - thus the compression and specifically decompression can be achieved in constant order. Any addition of new node also requires increasing the over all node count considering all the pattern trees or forest. Total number of node count directly determines the total amount of bits required to represent the code. Therefore, the system increments the total node counts and the new bit length of the codes is calculated (240) and the control is existed at 240 and ultimately flows back to 215.

In 222, if there is child node present under the present level, then the control comes directly to 223 and the values of TRAV_CHILD and LAST_ACCESSED_NODE_CHILD_COUNT are updated. Then the system checks (224) if the traversal has reached the end or not. If yes, this is the case of addition of new child-node at the end of the sibling list of the parent. Thus, steps from 230 to 241 are repeated and the process gets terminated and the control finally goes to 215. If check at 224 returns no, then the system checks (242) if code accumulation is going on in the present level or not. If not, then the control directly goes to step 225. If code accumulation is going on, then the system checks (243) if the traversed child is pointing to the 1st sibling or not. If the traversed child is pointing towards the first sibling, then the accumulated code is updated (244) as ACCUM_CODE [CURRENT_LEVEL] = ACCUM_CODE [CURRENT_LEVEL] + 1, else the accumulated code of current level is updated (245) as ACCUM_CODE [CURRENT_LEVEL] = ACCUM_CODE [CURRENT_LEVEL] + LAST_ACCESSED_CHILD_NODE_COUNT

The above steps (at 244 or 245) ensures that code is calculated using Depth First Traversal way in the compressor side without requiring to traverse all the nodes in the sub tree. After control comes back to 225, LAST_ACCESSED_CHILD_NODE_COUNT is updated with the total number of child nodes in the sub-tree under the traversed child. The system checks (226) if the traversed child has reached the end or not. If yes, the present level is assigned (228) to the traversed child and the accumulated level count is incremented by 1 and the flow ends there (229) and the control goes back to 215. If the traversed child has not reached the end (226), then the next sibling is traversed (227) and the control goes to 224.

After inserting the input symbol as described in 204, the control goes to 202. Further in 205, if the previous accumulated pattern length is found equal to zero, then the system finds out (207) the longest possible pattern of length L (<=k) accumulated in the tree rooted at left most symbol in the shift buffer. The length of longest possible repeated pattern starting with the symbol present at head of the shift-buffer can be found in ACCUM_LEVEL [k-1] i.e. L = ACCUM_LEVEL [k-1]. The unique code corresponding to the pattern can be found in ACCUM_CODE [k-1] and bit-length required to represent such code can be found in BIT-LENGTH [k-1]. Then the code is emitted (209) along with appropriate bit length in the compressed stream and the left most symbol from the shift buffer is removed.

In an embodiment, the system effectively manages the space complexity using a process called super imposition (210) of patterns. By performing superimposition of tree branches, the number of nodes can be minimized and thereby space requirement of the schema can be minimized. Such superimposition is driven by the fact that consecutive contents in shift buffer will have some part common amongst them.

In another embodiment, Super imposition of pattern can be explained as follows. Consider a stream of data "TOBEORNOTTOBEORTOBEORNOT". This input is parsed and is fed to a shift buffer of fixed length. Using the contents of shift buffer, pattern trees are constructed with trees rooted at different various symbols.

### Consider the following pattern trees

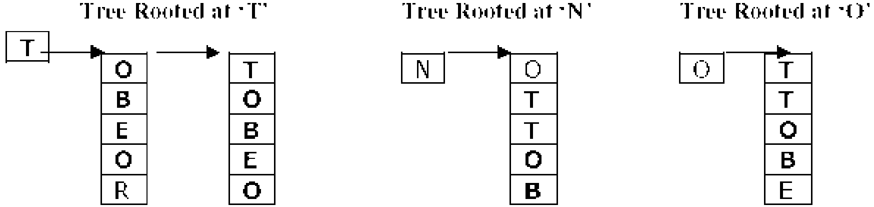

Now if we consider tree rooted at T, the pattern OBEO is repeating in both branches. So by using super imposition, the tree rooted at T can be modified as

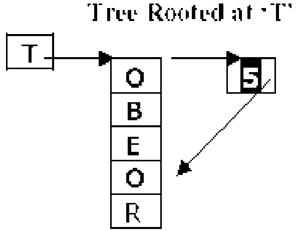

Similarly, if we consider tree rooted at 'N' and tree rooted at 'O', the pattern TTOB is repeated in both trees. So the tree rooted at 'N' and tree rooted at 'O' can be combined as

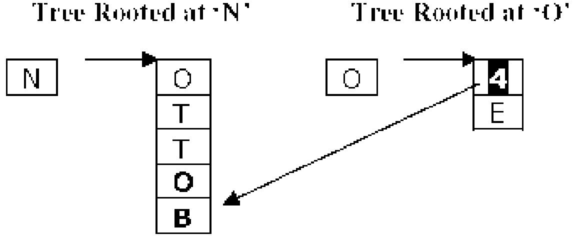

Here, in this case the common pattern "TTOB" is shared between the two trees. In this type of trees, treeNode maintains following information - "link to other tree node and number of Treenodes to be traversed to get the full string". Traversal should be done in reverse way. This is done to safeguard loop. If the traversal would have been done in order, there could have been possibility that "next" may point back to one of the tree node, already encountered in the path. Each tree node maintains information about its parent node. This information can be used while traversing in the reverse direction. Such tree nodes are called "Reverse Traversed tree node" (RT Tree Node). Now, when a new branch is to be created in an existing RT Treenode, the existing RT Treenode will have to be broken (234). Consider an example when a new pattern 'OTTXMF' is inserted in a tree rooted at 'O'. Now the pattern tree will be modified as follows

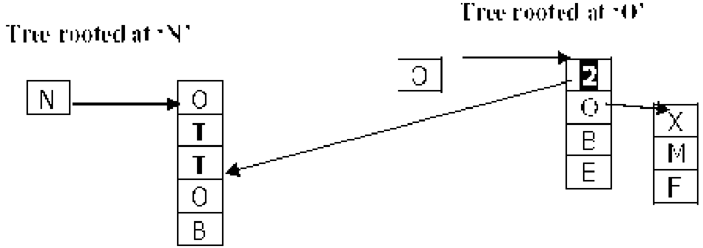

Here when the new pattern is inserted, tree rooted at 'O' is modified as given above. With insertion of the new pattern, the tree rooted at 'O' is split into three new "Treenodes". Now when a RT node is splitted there can be a situation where a RT tree node can be cross referenced from other 'Treenode'. In order to overcome such a situation, all new Treenodes are added as parents to 'RT Treenode' instead of adding as child nodes to 'RT Treenode'. This can be well understood from the following figures. As shown in the following figure, incoming link at RT Node 'RT (4) -> E' does not change with respect to the link address in the memory. However, type changes to normal node and content is changed to 'B'. The newly added normal node 'O' and the RT Node 'RT (2)' is added as parent to the old RT node.

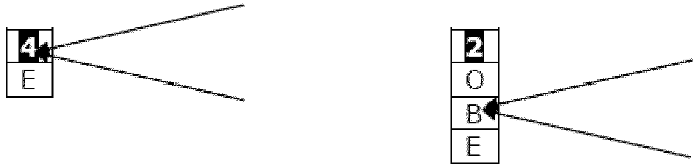

In a shift buffer, traversal happens from head to tail. That means tree corresponding to content at head is generated before trees corresponding to other cells in shift buffer. This rule helps a pattern tree corresponding to any cell of shift buffer to refer to tree generated before it, thereby helping to create reverse traversed Treenode on the fly. Such on the fly superimposition can be appreciated by observing the step at 211 where the new branch is stored for next superimposition and the control goes to 203 where the next symbol is read from the input and is inserted in the tail (or right-most position) of the shift buffer to perform above described operations again.

On top of superimposition, further there is way for space saving by exploiting 'Single branch path'. Single branch path means any path where there is one and only one Treenode at each level. If a 32 bit address is used, then any link requires 4 bytes to be stored. If single branch path is used, consecutive contents of the 'Treenode' will be stored under a single 'Treenode'. By doing so, space can be saved since it removes need for separately storing 'next' for each of the Treenode corresponding to individual contents. Given below is an example of how a single branch tree can be constructed from existing trees.

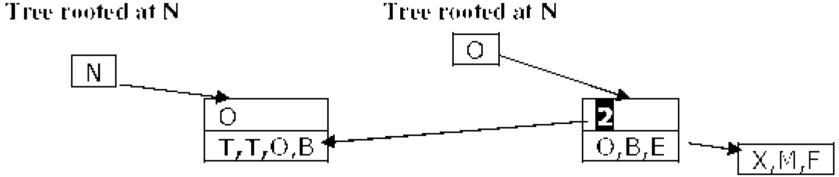

In another embodiment, the decoder disclosed in this system is a constant order decoder which is capable of effectively managing the run time complexity of the system. For that, PACS exploits the fundamental property of DFS traversal - If a node has left sibling, unique code for that node in DFS traversal is (unique code of left-sibling node + child nodes underneath the left-sibling + 1), else it is (unique code of parent node + 1). Consider the following figure.

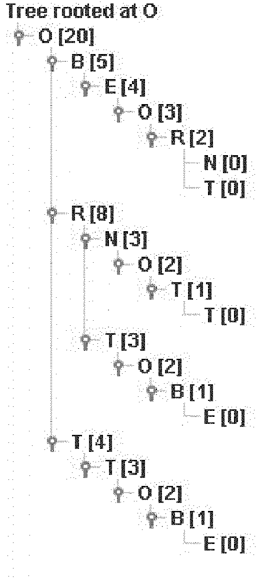

Let us consider that the decoder receives code = 15. According to DFS way of traversal, it indicates the pattern ORTOBE.

For the sake of the discussion, consider that decoder is presently pointing at root node of the tree - starting with unique code = 0. Now decoder first checks that how many child nodes are underneath the root node - it is 20 (indicated using []). Therefore, the code 15 must be under this node, because the extreme node under this tree will have 20 as the code if DFS traversal is made. So following DFS traversal, it comes down to 1^{st} child node under the root node i.e. it comes down to node 'B' and increments its unique code by 1 (according to the rule that if a node does not have any left sibling, its unique code = parent node + 1).

Further, decoder repeats the same process and check that how many child nodes are under node O->B). It observes that node 0->B has 5 child nodes under it i.e. the extreme child node (representing the pattern OBEORT) in the sub tree under this node will have unique code = 6. But the target code = 15. That implies the target code is residing in some sub tree following the sub tree rooted at node (0->B). Decoder now moves to (O-R). Note here that decoder need not traverse any of the child nodes under (0->B).

Now once reaching (0->R), decoder makes its present unique code = (unique code of '0->B' + child nodes underneath + 1) = (1 + 5 + 1) = 7. Now decoder uses the same logic and determines that extreme child in the sub tree under (0->R) will have code = (7 + 8) = 15. Therefore, it understand that the target code must be within sub tree under 'O>R'.

It traverses to next level just like usual DFS way. The unique code at 'O->R->N' becomes (7 + 1) = 8. It extends the logic in similar way i.e. the extreme child under 'O->R->N' will have DFS code = (8 + 3) = 11. Therefore, target code is in the next sub tree rooted at 'O->R->T' and so on.

It can be interpreted that the worst case runtime complexity for the decoder arrives when it needs to traverse to extreme child at every level of the tree. A tree can have maximum 'k' level (where 'k' is length of the sub tree) and at each level there can be maximum 'C' symbols (e.g. if the symbols of 8 bits, C = 256 etc.). Therefore, worst-case time complexity can be o( k * C) where both 'k' and 'C' are constant for the complete session of the algorithm.

In another embodiment, the aggressiveness of learning patterns in the input by the proposed compression scheme is higher than existing dictionary based schemes (e.g. variants of LZ78 etc.). Further, the proposed scheme is able to find out any pattern of length lesser than the length of shift buffer. Thus by making use of a shift buffer of proper length, all repeated patterns present in the input stream can be detected and compressed thereby assuring better compression efficiency. Such aggressiveness in pattern learning can be understood by the following example - let us consider a input 'wikipedia{Space}wikipedia{Space}wikipedia' where {Space} indicates single blank space. Note that the pattern - 'wikipedia' is repeated in the input data. When LZAP encounters the second 'wikipedia' pattern and identifies consecutively that 'wi', 'ki', 'pe' 'di' are four repeated patterns, it learns additionally 'wik', 'wiki', 'kip', 'kipe', 'ped' and 'pedi' patterns by appending every prefix of present match with the previous match. Therefore, LZAP will be able to exploit such learning when it encounters the third 'wikipedia' string where it can compress the repeated pattern - 'wiki' and 'pedi'. Now for PACS with shift-buffer length (k) = 8, the schema will be able to identify the repeated pattern 'wikipedi' in second occurrence of 'wikipedia' itself. Further, the third occurrence of 'wikipedia' can be compressed through repeated patterns 'a{Space}wikipe' and 'dia'.

### Use Cases

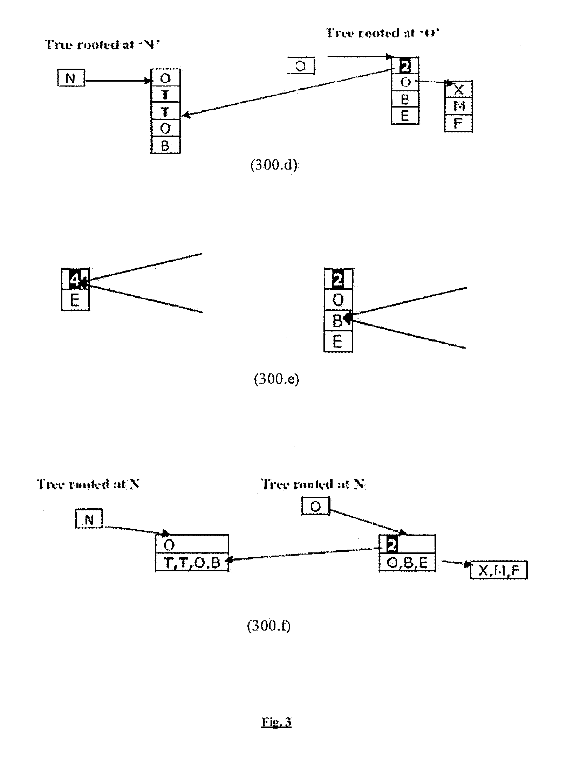

FIG. 3 illustrates a block diagram of the use case scenario of the Pattern Aware Compression Schemes (PACS) for compressing wireless data in the UMTS protocol stack of the system as disclosed in the embodiments herein. The system further comprises a User Equipment (UE) 301, Node B component 302 and a Radio Network Controller (RNC) 303.

Suppose the data to be compressed is in between the User Equipment (UE) 301 and the RNC 303. The compression algorithm (PACS) resides on top of RLC layer of the wireless communication system.. Using this compression algorithm, the Radio Network Controller (RNC) 303 and User Equipment (UE) 301 compress the data. Typically, in RNC side, the compression algorithm is implemented in dedicated hardware chips residing within the packet server cards present in the Radio Network Controller (RNC) 303.

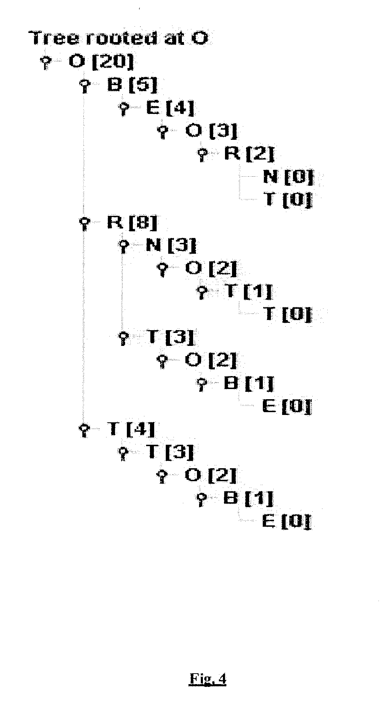

FIG. 4a and 4b illustrates a block diagram of the hardware component of the packet server present in Radio Network Controller (RNC) to implement PACS in the aforementioned use-case as disclosed in the embodiments herein. The Radio Network Controller (RNC) 303 shelf contains Packet Server Cards. Each Packet server card further consists of several processors, FPGA/DSP engines. The Data Compression Algorithm (PACS) resides in a processing engine called PMC RAB. PMC-RAB is responsible for MAC, RLC and any compression related processing on top of RLC e.g. PACS.

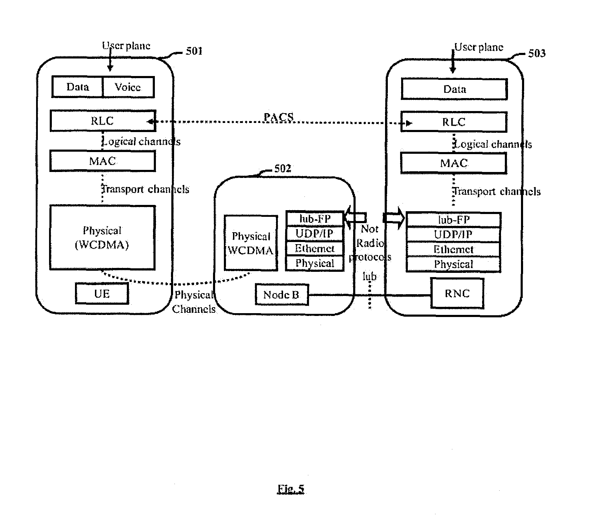

FIG. 5 illustrates use case scenario of PACS in the context of compressing wire-line data between two end-points of Internet (also known as tunnels) as disclosed in the embodiments herein. The system comprises a main office 501, branch office 502 and mobile users 503. The system shows compression of internet data between two site offices or between mobile user (accessing the site-office over VPN) and gateway of site/main offices. The data to be sent is compressed first using PACS and is encrypted and sent to the destination. At the point of reception, the data is first decrypted and then is decompressed using PACS. Typically PACS will be implemented using dedicated hardware chip residing in the site/main office gateways.

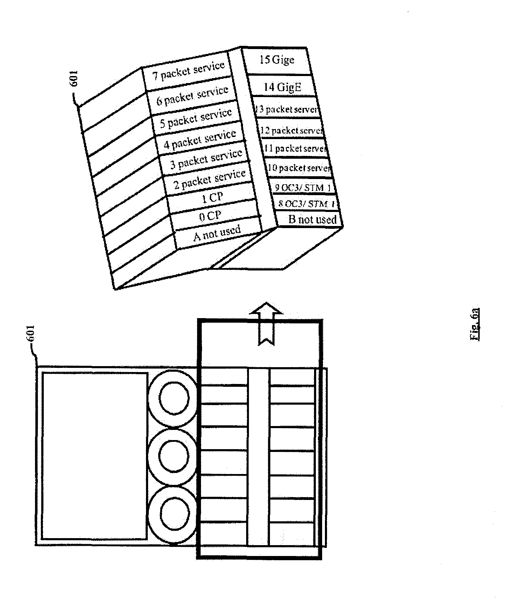

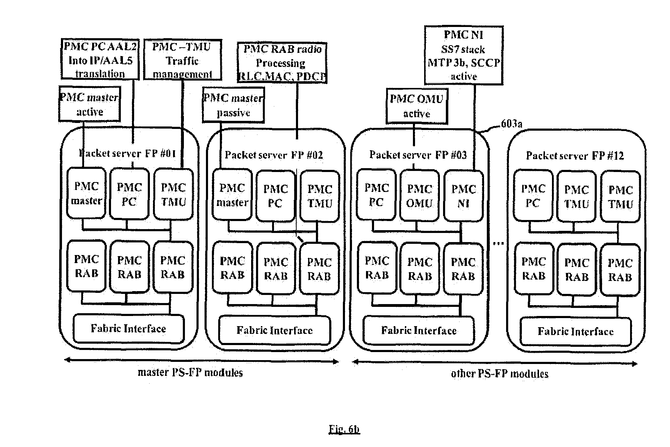

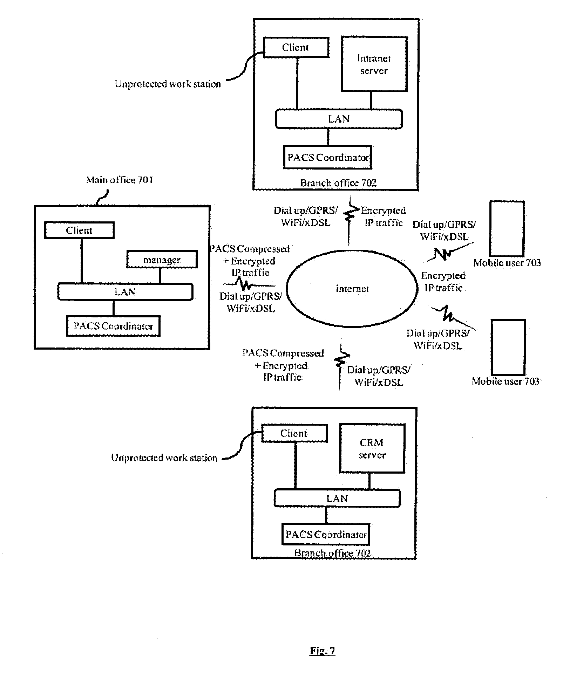

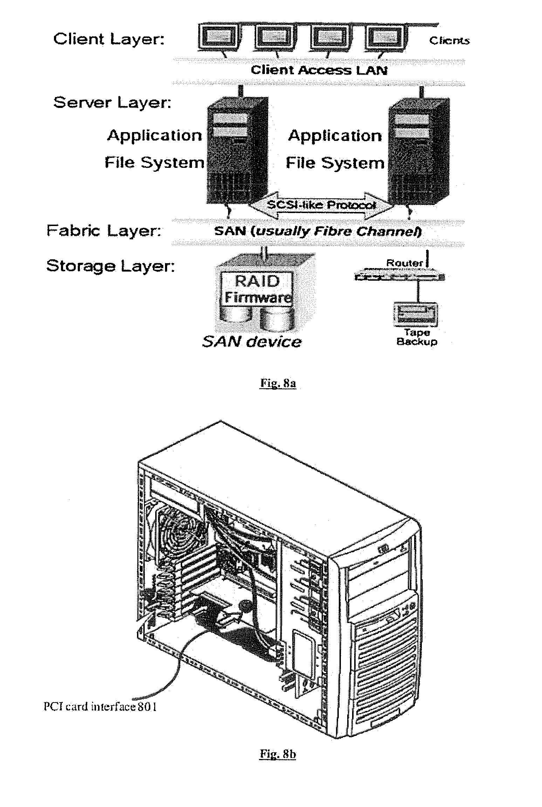

FIG.6a and 6b illustrates use case scenario of PACS in the context of traditional usage of compression in storage space. There are many scenarios where considering the amount of space required storing the raw data and the span of time to retain such data, it is almost mandatory to compress the raw data before saving to storage devices e.g. video surveillance, email backup system etc. Fig 6a shows typical such scenario where PACS compression/decompression will be used by the application file system server to write/read to/from the underlying storage layer. The application file system accesses the compression algorithm PACS through a PCI card interface 601 present in the system.

The embodiments disclosed herein can be implemented through at least one software program running on at least one hardware device and performing network management functions to control the network elements. The network elements shown in Fig. 3, 4, 5 and 6 include blocks which can be at least one of a hardware device, or a combination of hardware device and software module.

The foregoing description of the specific embodiments will so fully reveal the general nature of the embodiments herein that others can, by applying current knowledge, readily modify and/or adapt for various applications such specific embodiments without departing from the generic concept, and, therefore, such adaptations and modifications should and are intended to be comprehended within the meaning and range of equivalents of the disclosed embodiments. It is to be understood that the phraseology or terminology employed herein is for the purpose of description and not of limitation. Therefore, while the embodiments herein have been described in terms of preferred embodiments, those skilled in the art will recognize that the embodiments herein can be practiced with modification within the spirit and scope of the claims as described herein.

## Claims

1. A method for compressing data by employing a pattern aware compression scheme, said method comprising
passing an input through a shift buffer for identifying different possible patterns of said input;
creating a pattern tree in order to identify repeating patterns of said input;
identifying a longest repeated pattern from said created pattern tree; and
assigning unique codes to said repeated pattern.

2. The method as in claim 1, wherein said method passes said input through said shift buffer by inserting a new symbol at the tail of said shift buffer and deleting an old symbol from the head of said shift buffer.

3. The method as in claim 1, wherein said method creates said pattern tree by
rooting trees at a particular symbol and storing patterns starting with said symbol;
identifying child nodes for said rooted nodes; and
traversing said tree nodes to identify possible patterns starting with said root node.

4. The method as in claim 3, wherein said method traverses said tree nodes by employing depth first traversal algorithm.

5. The method as in claim 1, wherein said method identifies said longest repeated pattern by determining the pattern that takes the longest traversal (with respect to depth) from said root node to a last child node.

6. The method as in claim 1, wherein said method assigns unique codes to said repeated pattern, where said unique codes are determined by the number of traversals taken to reach the end symbol of said pattern.

7. The method as in claim 1, wherein said method further determines length of bit codes by computing minimum bits that are required to represent the total number of nodes of said tree present in said created pattern tree.

8. The method as in claim 1, wherein said method employs aggressive learning techniques and reduces the number of occurrences in identifying said repeating patterns from said created pattern tree.

9. A method for superimposing repeated patterns to achieve space optimization in data compression schemes, said method comprising
identifying if patterns present in different pattern trees share common nodes; and
replacing said common nodes with said codes.

10. The method as in claim 9, wherein said method identifies shared common nodes in said pattern tree by traversing said pattern tree in reverse order.

11. An encoder for compressing data by employing pattern aware compression schemes, said encoder is configured for
passing an input through a shift buffer for identifying different possible sequences of said input;
creating a pattern tree in order to identify possible repeating patterns of said input;
identifying a longest repeated pattern from said created pattern tree; and
assigning unique codes to said repeated pattern.

12. The encoder as in claim 11, wherein said encoder is further configured for passing said input through said shift buffer by inserting a new bit at the tail of said shift buffer and deleting an old bit from the head of said shift buffer.

13. The encoder as in claim 11, wherein said encoder is further configured for creating said pattern tree by
rooting trees at a particular node and storing patterns starting with said node;
identifying child nodes for said rooted nodes; and
traversing said tree nodes to identify possible patterns starting with said root node.

14. The encoder as in claim 11, wherein said encoder is further configured for traversing said tree nodes by employing depth first traversal algorithm.

15. The encoder as in claim 11, wherein said encoder is further configured for identifying said longest repeated pattern by determining the pattern that takes the longest traversal from said root node to a last child node.

16. The encoder as in claim 11, wherein said encoder is further configured for assigning unique codes to said repeated pattern, where said unique codes are determined by the number of traversals taken to reach the end of said pattern tree.

17. The encoder as in claim 11, wherein said encoder is further configured for determining said length of bit codes by computing minimum bits that are required to represent the total number of nodes of said tree present in said created tree pattern.

18. A decoder for decoding compressed data in a pattern aware compressing scheme, said decoder is configured for
identifying repeated patterns for unique codes in a pattern tree; replacing said unique codes with said repeated patterns for said pattern tree;
creating said pattern tree from said repeated patterns; and
decoding input from said created pattern tree.

19. The decoder as in claim 18, wherein said decoder is further configured for creating said pattern tree by
rooting trees at a particular node and storing patterns starting with said node;
identifying child nodes for said rooted nodes; and
traversing said tree nodes to identify possible patterns starting with said root node.

20. The decoder as in claim 18, wherein said decoder traverses said tree nodes by employing depth first traversal algorithm.

21. The decoder as in claim 18, wherein said decoder is further configured for replacing said unique codes to said repeated pattern, where said unique codes are the number of traversals taken to reach the end of said pattern tree.

22. The decoder as in claim 18, wherein said decoder is further configured for employing constant order decompression scheme to minimize the traversals in identifying a target node.

23. A method for decompressing data in a pattern aware compressing scheme, said method comprising
identifying repeated patterns for unique codes in a pattern tree; replacing said unique codes with said repeated patterns for said pattern tree;
creating said pattern tree from said repeated patterns; and
decoding input from said created pattern tree.

24. The method as in claim 23, wherein said method is further configured for creating said pattern tree by
rooting trees at a particular node and storing patterns starting with said node;
identifying child nodes for said rooted nodes; and
traversing said tree nodes to identify possible patterns starting with said root node.

25. The method as in claim 23, wherein said method traverses said tree nodes by employing depth first traversal algorithm.

26. The method as in claim 23, wherein said method is further configured for - replacing said unique codes to said repeated pattern, where said unique codes are the number of traversals taken to reach the end of said pattern tree.
